# EUROPÄISCHE PATENTSCHRIFT

(11) **EP 1 618 665 B1**
(45) Veröffentlichungstag und Bekanntmachung des Hinweises auf die Patenterteilung: **20.08.2008**
(21) Anmeldenummer: 04712561.2
(22) Anmeldetag: 19.02.2004
(51) Int. Cl.: H03K 19/086

(54) **FLIP-FLOP-SCHALTUNGSANORDNUNG**
FLIP-FLOP CIRCUIT ASSEMBLY
ENSEMBLE BASCULE

(30) Priorität: 28.04.2003 DE 10319089
(43) Veröffentlichungstag der Anmeldung: 25.01.2006
(73) Patentinhaber: austriamicrosystems AG, 8141 Unterpremstätten (AT)
(72) Erfinder: HÖSS, Wolfgang, Graz 8054 (AT)
(74) Vertreter: Epping - Hermann - Fischer
(86) Internationale Anmeldenummer: PCT/EP2004/001615
(87) Internationale Veröffentlichungsnummer: WO 2004/098061

(56) Entgegenhaltungen:
- EP-A- 0 599 517
- US-A- 5 828 237
- PATENT ABSTRACTS OF JAPAN vol. 1997, no. 07, 31. Juli 1997 (1997-07-31) -& JP 09 069759 A (MITSUBISHI ELECTRIC CORP), 11. März 1997 (1997-03-11)
- PATENT ABSTRACTS OF JAPAN vol. 1998, no. 04, 31. März 1998 (1998-03-31) -& JP 09 326682 A (NEC ENG LTD), 16. Dezember 1997 (1997-12-16)
- PATENT ABSTRACTS OF JAPAN vol. 015, no. 165 (E-1061), 25. April 1991 (1991-04-25) -& JP 03 034718 A (TOSHIBA CORP), 14. Februar 1991 (1991-02-14)

## Beschreibung

Die vorliegende Erfindung betrifft eine Flip-Flop-Schaltungsanordnung.

In integrierter Schaltungstechnik aufgebaute Flip-Flop-Schaltungen gehören zu den grundlegenden Schaltungsblöcken der integrierten Schaltungstechnik und haben eine Vielzahl von Anwendungsgebieten.

Flip-Flop-Schaltungen können beispielsweise mit emittergekoppelten Transistoren in ECL-Schaltungstechnik, Emitter Coupled Logic, aufgebaut werden.

Derartige Flip-Flop-Schaltungen zur schnellen Signalverarbeitung sind normalerweise symmetrisch aufgebaut und zur Verarbeitung von differentiellen Signalen ausgelegt.

Problematisch bei bekannten Flip-Flop-Schaltungen in ECL-Technik ist, daß diese aufgrund ihres Aufbaus normalerweise verhältnismäßig große Betriebsspannungen benötigen, da zwischen den beiden Versorgungspotentialen stets zumindest zwei Basis-Emitter-Spannungen abfallen. Insbesondere in der modernen Kommunikationselektronik ist es jedoch wünschenswert, Flip-Flop-Schaltungen mit immer geringer werdender Versorgungsspannung betreiben zu können.

Aufgabe der vorliegenden Erfindung ist es, eine Flip-Flop-Schaltungsanordnung anzugeben, welche in ECL-Schaltungstechnik aufbaubar ist und welche mit geringer Versorgungsspannung betrieben werden kann.

Erfindungsgemäß wird die Aufgabe gelöst durch eine Flip-Flop-Schaltungsanordnung, umfassend
- ein Paar von Eingangsanschlüssen, ausgelegt zum Zuführen eines differentiellen Eingangs-Taktsignals,
- ein Paar von Ausgangsanschlüssen, ausgelegt zum Abgreifen eines differentiellen Ausgangssignals,
- vier Differenzverstärker mit je zwei Transistoren, deren gesteuerte Strecken in je einer Serienschaltung mit einem Widerstand angeordnet sind, wobei die Serienschaltungen zwischen einem Versorgungspotentialanschluß und einem ersten beziehungsweise zweiten gemeinsamen Emitterknoten angeordnet sind, deren Steueranschlüsse unter Bildung einer D-Flipflop-Struktur miteinander gekoppelt sind und bei denen am Ausgang von zumindest einem Differenzverstärker das Paar von Ausgangsanschlüssen gebildet ist,
- eine erste Stromquelle, die den ersten gemeinsamen Emitterknoten mit einem Bezugspotentialanschluß verbindet,
- eine zweite Stromquelle, die den zweiten gemeinsamen Emitterknoten mit dem Bezugspotentialanschluß verbindet,
- einen ersten Schalter, der mit seiner gesteuerten Strecke zwischen Versorgungspotentialanschluß und ersten Emitterknoten geschaltet ist, und
- einen zweiten Schalter, der mit seiner gesteuerten Strecke zwischen Versorgungspotentialanschluß und zweiten Emitterknoten geschaltet ist,
- wobei der erste und der zweite Schalter je einen Steueranschluß haben, die das Paar von Eingangsanschlüssen bilden.

Die vorgeschlagene Flip-Flop-Schaltungsanordnung ist symmetrisch aufgebaut und zur Führung differentieller Signale ausgelegt.

Die Schaltung kann bevorzugt in ECL-Schaltungstechnik implementiert werden.

Gemäß dem vorgeschlagenen Prinzip ist vorgesehen, die beiden Schalter, die mit dem differentiellen Taktsignal angesteuert werden, von den beiden Emitterknoten aus direkt auf Versorgungspotential zu beziehen.

Demnach ergibt sich mit Vorteil, daß zwischen Versorgungspotentialanschluß und Bezugspotentialanschluß bei Realisierung der Differenzverstärkertransistoren und der Schalter in Bipolartechnik nur mehr lediglich eine Basis-Emitter-Spannung U_{BE} abfällt und somit die Schaltung vorteilhafterweise mit besonders geringer Spannung betrieben werden kann.

Außerdem entspricht es dem vorgeschlagenen Prinzip, daß lediglich zwei Stromquellen erforderlich sind, die die beiden gemeinsamen Emitterknoten jeweils mit Bezugspotential koppeln. Somit sind die Stromquellen für alle Differenzverstärker in einem Stromquellenpaar zusammengefaßt.

Ein zusätzlicher Vorteil des vorgeschlagenen Prinzips ergibt sich dadurch, daß durch die geringere Anzahl der erforderlichen Stromquellen der Strombedarf der Schaltung verringert ist.

Eine noch weitere Verringerung des Strombedarfs der Schaltung ergibt sich durch bevorzugtes Ausführen des ersten und des zweiten Schalters, die vom differentiellen Taktsignal angesteuert werden, als Transistoren, die als Emitterfolger arbeiten. Somit können mit Vorteil Emitterfolger am Ausgang der Flip-Flop-Schaltung entfallen.

Dennoch ist es mit der vorgeschlagenen Schaltung mit Vorteil möglich, den Ausgang eines wie vorgeschlagen ausgeführten Flip-Flops an einen Dateneingang desselben oder eines weiteren, gleichartigen Flip-Flops unmittelbar anzuschließen. Demnach können mit dem vorgeschlagenen Flip-Flop problemlos Frequenzteilerschaltungen und/oder Schieberegister aufgebaut und dennoch auf ausgangsseitige Emitterfolger verzichtet werden.

Gemäß einer bevorzugten Weiterbildung der vorgeschlagenen Flip-Flop-Schaltungsanordnung sind die vier Differenzverstärker so ausgeführt, daß
- ein erster Differenzverstärker vorgesehen ist umfassend ein erstes Paar von in dem ersten Emitterknoten emittergekoppelten Transistoren, deren Kollektoranschlüsse einen ersten Schaltungsknoten und einen zweiten Schaltungsknoten bilden und deren Basisanschlüsse über Kreuz mit deren Kollektoranschlüssen verbunden sind,
- ein zweiter Differenzverstärker vorgesehen ist umfassend ein zweites Paar von in dem zweiten Emitterknoten emittergekoppelten Transistoren, deren Kollektoranschlüsse mit dem ersten Schaltungsknoten beziehungsweise mit dem zweiten Schaltungsknoten verbunden sind und deren Basisanschlüsse einen dritten Schaltungsknoten und einen vierten Schaltungsknoten bilden,
- ein dritter Differenzverstärker vorgesehen ist umfassend ein drittes Paar von in dem zweiten Emitterknoten emittergekoppelten Transistoren, deren Kollektoranschlüsse mit dem dritten Schaltungsknoten beziehungsweise mit dem vierten Schaltungsknoten verbunden sind und deren Basisanschlüsse über Kreuz mit deren Kollektoranschlüssen verbunden sind, und daß
- ein vierter Differenzverstärker vorgesehen ist umfassend ein viertes Paar von in dem ersten Emitterknoten emittergekoppelten Transistoren, deren Kollektoranschlüsse mit dem dritten Schaltungsknoten beziehungsweise mit dem vierten Schaltungsknoten verbunden sind und deren Basisanschlüsse mit dem zweiten Schaltungsknoten beziehungsweise mit dem ersten Schaltungsknoten verbunden sind.

Gemäß einer weiteren, bevorzugten Ausführungsform des vorgeschlagenen Prinzips sind der erste, der zweite, der dritte und der vierte Schaltungsknoten, welche an jeweiligen Kollektoranschlüssen der Transistoren der Differenzverstärker gebildet sind, über je einen Widerstand mit dem Versorgungspotentialanschluß verbunden.

Die Widerstände können als Stromquellen ausgeführt sein. Die Stromquellen können als hierzu geeignet beschalteter Transistor ausgeführt sein. Die Stromquellentransistoren sind in diesem Fall bevorzugt als Feldeffekttransistoren ausgebildet.

Die Differenzverstärker sowie die beiden Schalter, die mit dem differentiellen Taktsignal angesteuert werden, sind bevorzugt in bipolarer Schaltungstechnik ausgeführt. Die Schalter- und Differenzverstärkertransistoren sind bevorzugt als npn-Transistoren ausgebildet.

Die erste und die zweite Stromquelle, welche:die beiden gemeinsamen Emitterknoten mit dem Bezugspotentialanschluß der Flip-Flop-Schaltung verbinden, sind bevorzugt in MOS-Schaltungstechnik ausgeführt und umfassen je einen Transistor. Die Stromquellentransistoren sind bevorzugt als n-Kanal-Transistoren von einem selbstleitenden Typ ausgeführt. Die Steueranschlüsse der Transistoren, die die erste und die zweite Stromquelle bilden, sind bevorzugt miteinander verbunden und an ein konstantes Referenzpotential gelegt. Dabei sind die Stromquellentransistoren bevorzugt jeweils Ausgangstransistor eines Stromspiegels. Alternativ können die erste und zweite Stromquelle auch als Widerstand oder BipolarTransistor ausgeführt sein.

Weitere Einzelheiten und vorteilhafte Ausgestaltungen des vorgeschlagenen Prinzips sind Gegenstand der Unteransprüche.

Die Erfindung wird nachfolgend an einem Ausführungsbeispiel anhand der einzigen Figur näher erläutert.

Es zeigt:
- die Figur: ein Ausführungsbeispiel der vorliegenden Flip-FlopSchaltungsanordnung aufgebaut in ECLSchaltungstechnik anhand eines Schaltplans.

Die Figur zeigt eine Flip-Flop-Schaltungsanordnung, welche symmetrisch aufgebaut ist und welche ausgelegt ist zur Verarbeitung differentieller Signale. Die vorliegende Flip-Flop-Schaltungsanordnung ist in sogenannter Emitter Coupled Logic(ECL)-Schaltungstechnik aufgebaut und bevorzugt als integrierte Schaltung realisiert.

Die Flip-Flop-Schaltungsanordnung umfaßt ein Paar von Eingangsanschlüssen CP, CN, an denen ein differentielles Taktsignal zugeführt werden kann. Das Paar von Eingangsanschlüssen CN, CP ist an je einem Basisanschluß je eines zugeordneten Transistors S1, S2 gebildet. Die npn-Transistoren S1, S2, welche als Schalter arbeiten, sind mit ihren beiden Kollektoranschlüssen unmittelbar mit einem Versorgungspotentialanschluß VCC verbunden. Der Emitteranschluß des ersten Schalters S1 ist mit einem ersten gemeinsamen Emitterknoten E1 verbunden. Der Emitteranschluß des zweiten Schalters S2 ist mit einem zweiten gemeinsamen Emitterknoten verbunden. Der erste und der zweite Emitterknoten E1, E2 sind über je eine Konstantstromquelle Q1, Q2 mit einem Bezugspotentialanschluß VEE verbunden. Die Konstantstromquellen Q1, Q2 sind vorliegend als MOS-Feldeffekttransistoren vom n-Kanal-Typ ausgeführt. Die Gateanschlüsse der Stromquellentransistoren Q1, Q2 sind miteinander verbunden und bilden einen Anschluß VNB zum Zuführen eines Referenzpegels. An diesen Anschluß ist bevorzugt eine Stromquelle über eine Transistordiode angeschlossen, so daß die Transistoren Q1, Q2 jeweils den ausgangsseitigen Transistor eines Stromspiegels bilden.

Den eigentlichen Kern der Flip-Flop-Schaltungsanordnung bilden insgesamt vier Differenzverstärker 1, 2, 3, 4, welche wie nachfolgend beschrieben mit ihren Ein- und Ausgängen mit den beiden Summenknoten E1, E2 verbunden sind. Die Transistoren der Differenzverstärker 1 bis 4 sind dabei in bipolarer Schaltungstechnik als npn-Transistoren ausgebildet und werden in ECL-Schaltungstechnik schaltend betrieben.

Der erste Differenzverstärker 1 umfaßt zwei emittergekoppelte Transistoren 5, 6, deren Emitteranschlüsse unmittelbar miteinander und mit dem ersten Emitterknoten E1 verbunden sind. Der Kollektoranschluß des ersten Transistors 5 des ersten Differenzverstärkers 1 bildet einen ersten Schaltungsknoten ON1, der Kollektoranschluß des zweiten Transistors 6 des ersten Differenzverstärkers 1 bildet einen zweiten Schaltungsknoten OP1. Der Basisanschluß des ersten Transistors 5 ist mit dem Kollektoranschluß des zweiten Transistors 6 und der Basisanschluß des zweiten Transistors 6 mit dem Kollektoranschluß des ersten Transistors 5 verbunden. Der erste Schaltungsknoten ON1 ist über einen ersten Widerstand R1 mit dem Versorgungspotentialanschluß VCC verbunden. Der zweite Schaltungsknoten OP1 ist über einen zweiten Widerstand R2 mit dem Versorgungspotentialanschluß VCC verbunden.

Der zweite Differenzverstärker 2 umfaßt einen ersten Transistor 7 und einen zweiten Transistor 8, deren Emitteranschlüsse miteinander und mit dem zweiten gemeinsamen Emitterknoten E2 verbunden sind. Der Kollektoranschluß des ersten Transistors 7 des zweiten Differenzverstärkers 2 ist mit dem ersten Schaltungsknoten ON1 verbunden, der Kollektoranschluß des zweiten Transistors 8 des zweiten Differenzverstärkers 2 ist mit dem zweiten Schaltungsknoten OP1 verbunden. Der Basisanschluß des ersten Transistors 7 ist mit einem dritten Schaltungsknoten ON2 verbunden, der Basisanschluß des zweiten Transistors 8 ist mit einem vierten Schaltungsknoten OP2 verbunden.

Der dritte Differenzverstärker 3 umfaßt einen ersten Transistor 9 und einen zweiten Transistor 10, deren Emitteranschlüsse miteinander und mit dem zweiten gemeinsamen Emitterknoten E2 der Schaltung verbunden sind. Kollektor- und Basisanschlüsse der Transistoren 9, 10 des dritten Differenzverstärkers 3 sind wie die Transistoren 5, 6 bei dem ersten Differenzverstärker 1 über Kreuz miteinander verbunden. Der Kollektoranschluß des ersten Transistors 9 des dritten Differenzverstärkers 3 ist an den dritten Schaltungsknoten ON2 angeschlossen, der Kollektoranschluß des zweiten Transistors 10 des dritten Differenzverstärkers 3 ist mit dem vierten Schaltungsknoten OP2 verbunden.

Der vierte Differenzverstärker 4 umfaßt zwei emittergekoppelte Transistoren 11, 12, deren gemeinsamer Emitteranschluß mit dem ersten Summenknoten beziehungsweise gemeinsamen Emitterknoten E1 verbunden ist. Der Kollektoranschluß des ersten Transistors 11 ist mit dem dritten Schaltungsknoten ON2, der Kollektoranschluß des zweiten Transistors 12 des vierten Differenzverstärkers 4 ist mit dem vierten Schaltungsknoten OP2 verbunden. Der Basisanschluß des ersten Transistors 11 ist mit dem zweiten Schaltungsknoten OP1 verbunden, der Basisanschluß des zweiten Transistors 12 des vierten Differenzverstärkers 4 ist mit dem ersten Schaltungsknoten ON1 verbunden.

Der dritte und der vierte Schaltungsknoten ON2, OP2 bilden das Paar von Ausgangsanschlüssen QN, QP der Flip-Flop-Schaltungsanordnung.

Die vier Schaltungsknoten ON1, OP1, ON2, OP2 der Schaltungsanordnung sind über je einen Widerstand R1, R2, R3, R4 mit dem Versorgungspotentialanschluß VCC verbunden.

Die zum Betrieb der Schaltung gemäß der Figur erforderliche Versorgungsspannung ergibt sich aus der Potentialdifferenz zwischen dem Versorgungspotentialanschluß VCC und dem Bezugspotentialanschluß VEE. Die zumindest erforderliche Spannung ergibt sich aus der Summe von insgesamt drei Spannungen, nämlich der Spannung, die über den Widerständen R1 bis R4 abfällt, einer Basis-Emitter-Spannung, die über den Transistoren 5 bis 12, S1, S2 abfällt und einer Stromquellenspannung, die über den Stromquellen Q1, Q2 abfällt. Bei der gezeigten Schaltung, bei der beispielhaft über den Kollektorwiderständen ein Hub von 0,3 V, an den Stromspiegeltransistoren Q1, Q2 ein Spannungsabfall von ebenfalls 0,3 V und eine an den Transistoren 5 bis 12, S1, S2 eine Basis-Emitter-Spannung von 0,9 V vorgesehen ist, ergibt sich im vorliegenden Zahlenbeispiel eine Mindest-Versorgungsspannung zum realistischen Betrieb des D-Flip-Flops von lediglich 1,5 V.

Die beiden Schalter S1, S2 arbeiten als Emitterfolger und sind in einer Bypass-Schaltung an die Summenknoten E1, E2 der Differenzverstärker 1 bis 4 angeschaltet. Demnach ist die Funktionalität eines Ausgangsemitterfolgers bereits in die Schaltung integriert, so daß am Ausgang QN, QP der Schaltung mit Vorteil kein Emitterfolger nötig ist. Demnach bietet die Schaltung eine zusätzliche Stromersparnis.

Die Schaltung gemäß der Figur ist besonders dazu geeignet, als Frequenzteiler verschaltet zu werden, der eine Frequenzteilung durch zwei bewirkt. Hierfür sind die Ausgänge QN, QP des Flip-Flops, welches ein D-Flip-Flop ist, mit den Daten-Eingängen des Flip-Flops in einer negativen Rückkopplung zu verbinden. Am Ausgang QN, QP kann dann ein Signal mit der halbierten, am Takteingang CN, CP anliegenden Taktfrequenz abgegriffen werden.

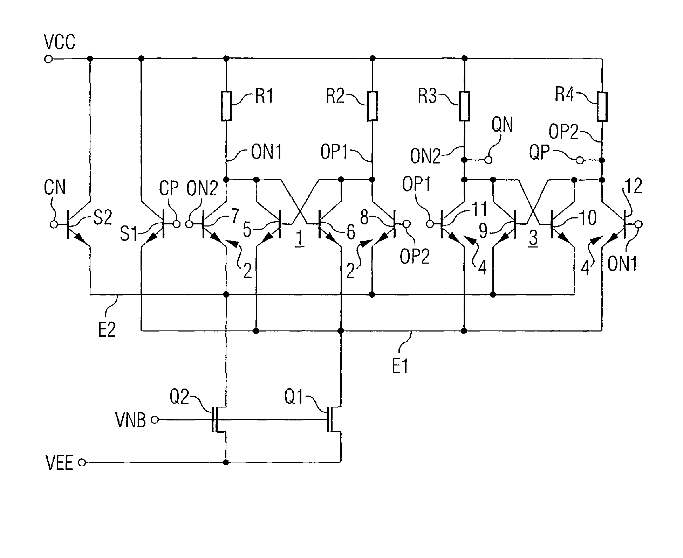

Ein weiteres, bevorzugtes Anwendungsgebiet der Schaltung liegt in dem Aufbau von Schieberegistern. Hierfür werden die Ausgänge QN, QP eines Flip-Flops gemäß Figur 1 jeweils mit dem Dateneingangspaar eines nachgeschalteten, gleichartigen Flip-Flops verbunden. Die Takteingänge CN, CP aller in solcher Weise zu einem Schieberegister verschalteten Flip-Flops werden miteinander und mit einem gemeinsamen Takteingang des Registers verbunden.

In alternativen Ausführungen der Erfindung kann beispielsweise anstelle der Widerstände R1 bis R4 ein Transistor vorgesehen sein. Ebenso können Bipolartransistoren durch unipolare Feldeffekt-Transistoren ersetzt werden und/oder umgekehrt.

## Patentansprüche

1. Flip-Flop-Schaltungsanordnung, umfassend
- ein Paar von Eingangsanschlüssen (CP, CN), ausgelegt zum Zuführen eines differentiellen Taktsignals,
- ein Paar von Ausgangsanschlüssen (QP, QN), ausgelegt zum Abgreifen eines differentiellen Ausgangssignals,
- vier Differenzverstärker (1, 2, 3, 4) mit je zwei Transistoren (5, 6; 7, 8; 9, 10; 11, 12), deren gesteuerte Strekken in je einer Serienschaltung mit einem Widerstand (R1, R2, R3, R4) angeordnet sind, wobei die Serienschaltungen zwischen einem Versorgungspotentialanschluß (VCC) und einem ersten beziehungsweise zweiten gemeinsamen Emitterknoten (E1, E2) angeordnet sind, deren Steueranschlüsse unter Bildung einer D-Flipflop-Struktur miteinander gekoppelt sind und bei denen am Ausgang von zumindest einem Differenzverstärker (3) das Paar von Ausgangsanschlüssen (QP, QN) gebildet ist,
- eine erste Stromquelle (Q1), die den ersten gemeinsamen Emitterknoten (E1) mit einem Bezugspotentialanschluß (VEE) verbindet,
- eine zweite Stromquelle (Q2), die den zweiten gemeinsamen Emitterknoten (E2) mit dem Bezugspotentialanschluß (VEE) verbindet,
- einen ersten Schalter (S1), der mit seiner gesteuerten Strecke zwischen den Versorgungspotentialanschluß (VCC) und den ersten Emitterknoten (E1) geschaltet ist, und
- einen zweiten Schalter (S2), der mit seiner gesteuerten Strecke zwischen den Versorgungspotentialanschluß (VCC) und den zweiten Emitterknoten (E2) geschaltet ist,
- wobei der erste und der zweite Schalter (S1, S2) je einen Steueranschluß haben, die das Paar von Eingangsanschlüssen (CP, CN) bilden.

2. Flip-Flop-Schaltungsanordnung nach Anspruch 1,
**dadurch gekennzeichnet daß**
- ein erster Differenzverstärker (1) vorgesehen ist umfassend ein erstes Paar von in dem ersten Emitterknoten (E1) emittergekoppelten Transistoren (5, 6), deren Kollektoranschlüsse einen ersten Schaltungsknoten (ON1) und einen zweiten Schaltungsknoten (OP1) bilden und!deren Basisanschlüsse über Kreuz mit deren Kollektoranschlüssen verbunden sind,
- ein zweiter Differenzverstärker (2) vorgesehen ist umfassend ein zweites Paar von in dem zweiten Emitterknoten (E2) emittergekoppelten Transistoren (7, 8), deren Kollektoranschlüsse mit dem ersten Schaltungsknoten (ON1) beziehungsweise mit dem zweiten Schaltungsknoten (OP1) verbunden sind und deren Basisanschlüsse einen dritten Schaltungsknoten (ON2) und einen vierten Schaltungsknoten (OP2) bilden,
- ein dritter Differenzverstärker (3) vorgesehen ist umfassend ein drittes Paar von in dem zweiten Emitterknoten (E2) emittergekoppelten Transistoren (9, 10), deren Kollektoranschlüsse mit dem dritten Schaltungsknoten (ON2) beziehungsweise mit dem vierten Schaltungsknoten (OP2) verbunden sind und deren Basisanschlüsse über Kreuz mit deren Kollektoranschlüssen verbunden sind, und daß
- ein vierter Differenzverstärker (4) vorgesehen ist umfassend ein viertes Paar von in dem ersten Emitterknoten (E1) emittergekoppelten Transistoren (11, 12), deren Kollektoranschlüsse mit dem dritten Schaltungsknoten (ON2) beziehungsweise mit dem vierten Schaltungsknoten (OP2) verbunden sind und deren Basisanschlüsse mit dem zweiten Schaltungsknoten (OP1) beziehungsweise mit dem ersten Schaltungsknoten (ON1) verbunden sind.

3. Flip-Flop-Schaltungsanordnung nach Anspruch 2,
**dadurch gekennzeichnet, daß**
der erste, der zweite, der dritte und der vierte Schaltungsknoten (ON1, OP1, ON2, OP2) über je einen Widerstand (R1, R2, R3, R4) mit dem Versorgungspotentialanschluß. (VCC) verbunden sind.

4. Flip-Flop-Schaltungsanordnung nach einem der Ansprüche 1 bis 3,
**dadurch gekennzeichnet, daß**
der erste, der zweite, der dritte und der vierte Differenzverstärker (1, 2, 3, 4) sowie der erste und der zweite Schalter (S1, S2) in bipolarer Schaltungstechnik ausgeführt sind.

5. Flip-Flop-Schaltungsanordnung nach einem der Ansprüche 1 bis 4,
**dadurch gekennzeichnet, daß**
die erste Stromquelle und die zweite Stromquelle (Q1, Q2) je einen Transistor in Metal Oxide Semiconductor-Schaltungstechnik umfassen.

6. Flip-Flop-Schaltungsanordnung nach einem der Ansprüche 1 bis 5,
**dadurch gekennzeichnet, daß**
diese in Emitter Coupled Logic-Schaltungstechnik implementiert ist.

## Claims

1. Flip-flop circuit arrangement, comprising
- a pair of input terminals (CP, CN), designed for feeding in a differential clock signal,
- a pair of output terminals (QP, QN), designed for tapping off a differential output signal,
- four differential amplifiers (1, 2, 3, 4) each having two transistors (5, 6; 7, 8; 9, 10; 11,12), the controlled paths of which are arranged in a respective series circuit with a resistor (R1, R2, R3, R4), the series circuits being arranged between a supply potential terminal (VCC) and a first and respectively second common emitter node (E1, E2), the control terminals of which are coupled to one another to form a D-type flip-flop structure and in which the pair of output terminals (QP, QN) is formed at the output of at least one differential amplifier (3),
- a first current source (Q1), which connects the first common emitter node (E1) to a reference potential terminal (VEE),
- a second current source (Q2), which connects the second common emitter node (E2) to the reference potential terminal (VEE),
- a first switch (S1), which is connected with its control path between the supply potential terminal (VCC) and the first emitter node (E1), and
- a second switch (S2), which is connected with its control path between the supply potential terminal (VCC) and the second emitter node (E2),
- the first and the second switch (S1, S2) each having a control terminal, which form the pair of input terminals (CP, CN).

2. Flip-flop circuit arrangement according to Claim 1,
**characterized in that**
- a first differential amplifier (1) is provided comprising a first pair of transistors (5, 6) which are emitter-coupled at the first emitter node (E1), the collector terminals of which form a first circuit node (ON1) and a second circuit node (OP1) and the base terminals of which are cross-connected to their collector terminals,
- a second differential amplifier (2) is provided comprising a second pair of transistors (7, 8) which are emitter-coupled at the second emitter node (E2), the collector terminals of which are connected to the first circuit node (ON1) and to the second circuit node (OP1), respectively, and the base terminals of which form a third circuit node (ON2) and a fourth circuit node (OP2),
- a third differential amplifier (3) is provided comprising a third pair of transistors (9, 10) which are emitter-coupled at the second emitter node (E2), the collector terminals of which are connected to the third circuit node (ON2) and to the fourth circuit node (OP2), respectively, and the base terminals of which are cross-connected to their collector terminals, and **in that**
- a fourth differential amplifier (4) is provided comprising a fourth pair of transistors (11, 12) which are emitter-coupled at the first emitter node (E1), the collector terminals of which are connected to the third circuit node (ON2) and to the fourth circuit node (OP2), respectively, and the base terminals of which are connected to the second circuit node (OP1) and to the first circuit node (ON1), respectively.

3. Flip-flop circuit arrangement according to Claim 2,
**characterized in that**
the first, the second, the third and the fourth circuit node (ON1, OP1, ON2, OP2), are connected to the supply potential terminal (VCC) via a respective resistor (R1, R2, R3, R4).

4. Flip-flop circuit arrangement according to any of Claims 1 to 3,
**characterized in that**
the first, the second, the third and the fourth differential amplifier (1, 2, 3, 4) and also the first and the second switch (S1, S2) are embodied using bipolar circuit technology.

5. Flip-flop circuit arrangement according to any of Claims 1 to 4,
**characterized in that**
the first current source and the second current source (Q1, Q2) each comprise a transistor using metal oxide semiconductor circuit technology.

6. Flip-flop circuit arrangement according to any of Claims 1 to 5,
**characterized in that**
it is implemented using emitter coupled logic circuit technology.

## Revendications

1. Montage bascule comprenant
- une paire de bornes (CP, CN) d'entrée, conçue pour envoyer un signal d'horloge différentiel,
- une paire de bornes (QP, QN) de sortie, conçue pour prélever un signal de sortie différentiel ;
- quatre amplificateurs (1, 2, 3, 4) différentiels ayant chacun deux transistors (5, 6 ; 7, 8 ; 9, 10 ; 11, 12), dont les sections commandées sont montées dans, respectivement, un circuit série avec une résistance (R1, R2, R3, R4), le circuit série étant monté entre une borne (VCC) de potentiel d'alimentation et un premier ou un deuxième noeud (E1, E2 ) d'émetteur commun, dont les bornes de commande sont couplées entre elles en formant une structure de bascule D et dans lequel la paire de bornes (QP, QN) de sortie est formée à la sortie d'au moins un amplificateur (3) différentiel,
- une première source (Q1) de courant, qui relie le premier noeud (E1) d'émetteur commun à une borne (VEE) de potentiel de référence,
- une deuxième source (Q2) de courant, qui relie le deuxième noeud (E2) d'émetteur commun à la borne (VEE) de potentiel de référence,
- un premier commutateur (S1), qui est monté par sa section commandée entre la borne (VCC) de potentiel d'alimentation et le premier noeud (E1) d'émetteur, et
- un deuxième commutateur (S2), qui est monté par sa section commandée entre la borne (VCC) de potentiel d'alimentation et le deuxième noeud (E2) d'émetteur,
- dans lequel le premier et le deuxième commutateur (S1, S2) ont, respectivement, une borne de commande qui forme la paire de bornes (CP, CN) d'entrée.

2. Montage bascule suivant la revendication 1,
**caractérisé en ce que**
- il est prévu un premier amplificateur (1) différentiel comprenant une première paire de transistors (5, 6) qui sont couplés par émetteur dans le premier noeud (E1) d'émetteur et dont les bornes de collecteur forment un premier noeud (ON1) de circuit et un deuxième noeud (OP1) de circuit et dont les bornes de base sont reliées par croisement à leurs bornes de collecteur,
- il est prévu un deuxième amplificateur (2) différentiel comprenant une deuxième paire de transistors (7, 8) qui sont couplés par émetteur dans le deuxième noeud (E2) d'émetteur et dont les bornes de collecteur sont reliées au premier noeud (ON1) de circuit ou, respectivement, au deuxième noeud (OP1) de circuit et dont les bornes de base forment un troisième noeud (ON2) de circuit et un quatrième noeud (OP2) de circuit,
- il est prévu un troisième amplificateur (3) différentiel comprenant une troisième paire de transistors (9, 10) qui sont couplés par émetteur dans le deuxième noeud (E2) d'émetteur et dont les bornes de collecteur sont reliées au troisième noeud (ON2) de circuit ou au quatrième noeud (OP2) de circuit et dont les bornes de base sont reliées par croisement à leurs bornes de collecteur, et **en ce que**
- il est prévu un quatrième amplificateur (4) différentiel comprenant une quatrième paire de transistors (11, 12) qui sont couplés par émetteur dans le premier noeud (E1) d'émetteur et dont les bornes de collecteur sont reliées au troisième noeud (ON2) de circuit ou au quatrième noeud (OP2) de circuit et dont les bornes de base sont reliées au deuxième noeud (OP1) de circuit ou au premier noeud (ON1) de circuit.

3. Montage bascule suivant la revendication 2,
**caractérisé en ce que**
le premier, le deuxième, le troisième et le quatrième noeud (ON1, OP1, ON2, OP2) de circuit sont reliés à la borne (VCC) de potentiel d'alimentation par, respectivement, une résistance (R1, R2, R3, R4).

4. Montage bascule suivant l'une des revendications 1 à 3, **caractérisé en ce que** le premier, le deuxième, le troisième et le quatrième amplificateur (1, 2, 3, 4) différentiel ainsi que le premier et le deuxième commutateur (S1, S2) sont réalisés en technique de circuit bipolaire.

5. Montage bascule suivant l'une des revendications 1 à 4, **caractérisé en ce que** la première source (Q1) de courant et la deuxième source (Q2) de courant comprennent, respectivement, un transistor en technique de circuit métal oxyde semi-conducteur.

6. Montage bascule suivant l'une des revendications 1 à 5,
**caractérisé en ce que**
ce montage est mis en oeuvre en technique de circuit logique couplé par émetteur.
